Europäisches Patentamt

European Patent Office

Office européen des brevets

(19)

(11) Veröffentlichungsnummer : **0 034 706
B1**

(12) # EUROPÄISCHE PATENTSCHRIFT

(45) Veröffentlichungstag der Patentschrift :
02.05.84

(51) Int. Cl.³ : **C 23 F 1/00, C 23 C 11/00,
C 23 C 15/00**

(21) Anmeldenummer : 81100455.5

(22) Anmeldetag : 22.01.81

(54) Verfahren und Vorrichtung zum Plasmaätzen oder zur Plasma CVD.

(30) Priorität : 08.02.80 DD 218956

(43) Veröffentlichungstag der Anmeldung :
02.09.81 Patentblatt 81/35

(45) Bekanntmachung des Hinweises auf die Patenterteilung : 02.05.84 Patentblatt 84/18

(84) Benannte Vertragsstaaten :
CH DE FR GB LI

(56) Entgegenhaltungen :
EP-A- 0 016 603
DE-A- 2 251 571
DE-A- 2 541 719
DE-B- 2 810 554
GB-A- 1 391 842

(73) Patentinhaber : **VEB Zentrum für Forschung und Technologie Mikroelektronik
Karl-Marx-Strasse
DDR-8080 Dresden (DD)**

(72) Erfinder : **Rudakoff, Georg, Prof.Dr. Habil.
Leo-Sachse-Strasse 34
DDR-6900 Jena (DD)**
Erfinder : **Tiller, Hans-Jürgen, Dr.sc.
Emil-Wölk-Strasse 2
DDR-6900 Jena (DD)**
Erfinder : **Göbel, Roland, Dipl.-Phys.
Heimstättenstrasse 12
DDR-6900 Jena (DD)**
Erfinder : **Voigt, Reinhard, Dipl-Phys.
Gerh.Hauptmann-Strasse 18
DDR-8102 Langebrück (DD)**
Erfinder : **Schade, Klaus, Dr. Dipl.-Ing.
Florian-Geyer-Strasse 15/48
DDR-8019 Dresden (DD)**
Erfinder : **Kosch, Wolfgang
Geschw.-Scholl-Strasse 94
DDR-8080 Dresden (DD)**
Erfinder : **Gehmlich, Konrad, Dipl.-Phys.
Bautzner Strasse 129
DDR-8060 Dresden (DD)**

(74) Vertreter : **Braun, André et al
A. Braun, Braun, Héritier, Eschmann AG Patentanwälte Holbeinstrasse 36-38
CH-4051 Basel (CH)**

## Verfahren und Vorrichtung zum Plasmaätzen oder zur Plasma CVD

Die Erfindung betrifft ein Verfahren und eine Vorrichtung zur Durchführung des Verfahrens zum plasmachemischen Ätzen oder reaktiven Ionenätzen von Halbleitern und deren Verbindungen, Metallen und Metallverbindungen, Gläsern und keramischen Erzeugnissen sowie organischen Materialien wie zum Beispiel Fotolack und zur Plasma CVD von Halbleitern, Halbleiterverbindungen, Metallen und Metallverbindungen.

Verfahren zum plasmachemischen Ätzen und zur Plasma CVD von Halbleitern und deren Verbindungen sind bekannt. Dabei wird das zu behandelnde Material in einen Rezipienten auf einer als Elektrode ausgebildeten Halterung postiert, ein Reaktionsgas in den Rezipienten eingeleitet und durch Erregung der Elektroden ionisiert und ein Plasma ausgebildet. Dabei ist zu der als Halterung ausgebildeten Elektrode zumeist in einem gewissen Abstand parallel eine Gegenelektrode angeordnet. Es sind vier grundsätzliche Elektrodenanordnungen für die Hochfrequenzentladung bekannt.

Anordnungen, bei denen eine Elektrode auf Massepotential liegt und die Substrate auf der « heißen » Elektrode angeordnet sind, werden in den US-A 3 971 684 ; 3 984 301 ; 3 994 793 und in der DE-AS 2 449 731 beschrieben. In der DE-OS 2 730 156 und in der US-A 3 757 733 sind Anordnungen beschrieben, bei denen die Substrate auf einer Masseelektrode liegen, wobei die heiße Elektrode innerhalb oder außerhalb des Rezipienten angeordnet ist. Gleiche Anordnungen sind auch aus den DE-OS 2 730 156 und 2 708 720 bekannt, bei denen jedoch die Substrate oder die Elektrode gefloatet sind. Aus der DE-OS 2 800 180 ist eine Anordnung bekannt, bei der über eine variable Impedanz eine Vorspannung an die Zielelektrode angeschlossen wird. Diese beschriebenen Anordnungen werden zur Erzielung einer größeren Homogenität des Ätzprozesses dahingehend modifiziert, daß durch besondere Gestaltung der Elektrodenform (DE-OS 2 241 229), durch Einbringen eines geeignet gestalteten Dielektrikums (zum Beispiel DE-OS 2 708 720), oder durch Bewegung der Substrate (zum Beispiel DE-AS 2 757 498) räumlich oder zeitlich homogene Potential- beziehungsweise Gasströmungsverhältnisse geschaffen werden.

Aus der DE-B 2 810 554 ist eine Vorrichtung zur Plasmabehandlung bei der Halbleiterbauelementeherstellung bekannt. Die Fig. 6 und 7 dieses Dokumentes zeigen Anordnungen von zueinander parallelen mit Substraten belegten Elektroden ; das Plasma erstreckt sich aber in beiden Fällen nicht zwischen zwei auf gleichem Potential liegenden Substratflächen. In Fig. 6 ist eindeutig dargestellt, dass die Substrate 5 mittels der Elektrodenplatten 2 abwechselnd auf unterschiedlichem Potential gehalten werden. Die in Fig. 7 dargestellten Hilfselektroden 11 dienen zur Abschirmung der Substrate 5 ; dabei wird jeweils zwischen benachbarten Hilfselektroden 11 von entgegengesetzter Polarität eine Plasmaentladung erzeugt. Es handelt sich bei beiden Figuren um bekannte Diodenanordnungen.

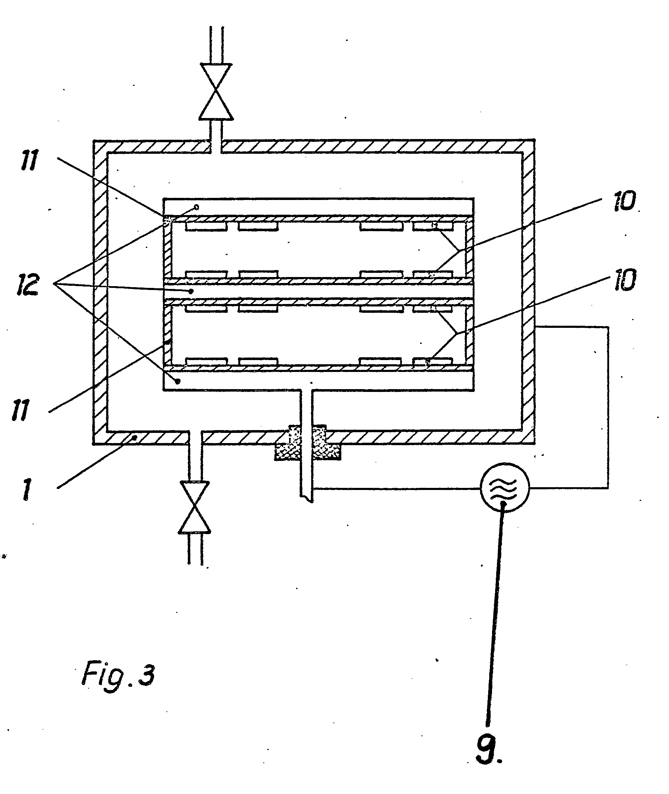

Die GB-A 1 391 842 bezieht sich auf eine Vorrichtung zum Beschichten von Substraten durch Kathodenzerstäubung und zum Reinigen durch Ionenbeschuss im gleichen Vakuumgefäss. Bei den in den Fig. 3 und 6 dargestellten Ausführungsformen liegen zwar die Substrate 6 bzw. 16 auf gleichem Potential, aber zwischen den Substratelektroden 5 bzw. 15 liegt jeweils eine Elektrode 1 bzw. 11 mit anderem Potential ; es handelt sich daher um eine Reihe von nebeneinander angeordneten Diodenanordnungen.

Die beschriebenen Anordnungen sind alle sowohl vom elektrischen als auch vom mechanischen Aufbau her unsymmetrisch, wodurch Potentialinhomogenitäten entstehen, so daß jeweils nur begrenzte Bereiche einer Elektrodenfläche zur Substratbehandlung herangezogen werden können.

Außerdem können diese unsymmetrischen Anordnungen bei der Verwendung von Ätzgasen, die zur Verunreinigung des Reaktionsraumes durch Zersetzungsprodukte neigen, zur Schichtabscheidung auf einer Elektrode führen. Dadurch werden die Substrate einem erhöhten Verunreinigungsrisiko ausgesetzt. Als weiterer Nachteil ist die Inhomogenität in der Temperaturverteilung und damit eine Inhomogenität in der bekannterweise temperaturabhängigen Ätzrate zu sehen. Ferner ergeben die einfachen unsymmetrischen Diodenanordnungen eine Entladung von relativ niedrigem Ionisationsgrad, so daß bei relativ hohen Druckwerten gearbeitet werden muß. Daraus resultieren geringe freie Weglängen, die einer Homogenisierung des Ätzeffektes ebenfalls entgegenstehen.

Ziel der Erfindung ist es, eine höhere Arbeitsproduktivität bei der Bearbeitung von Halbleitersubstraten oder anderen für dieses Verfahren in Frage kommenden Materialien zu ermöglichen und gleichzeitig bei der Verwendung von Ätzgasen, die zur Verunreinigung des Reaktionsraumes durch Zersetzungsprodukte neigen, eine Verunreinigung zu vermeiden.

Die Aufgabe der Erfindung besteht darin, die bekannten Plasmaverfahren zur Bearbeitung von Substraten dahingehend zu verbessern, daß eine homogene Verteilung der Ätzrate erreicht wird, und die für dieses Verfahren erforderliche Veränderungen an den bekannten Vorrichtungen anzugeben.

Erfindungsgemäß wird die Aufgabe dadurch gelöst, daß das Plasma sich hauptsächlich zwischen zwei oder mehreren in einem von den Entladungsbedingungen abhängigen Abstand parallel zueinander angeordneten mit Substraten belegten Elektroden erstreckt, die gegenüber dem sie umgebenden Rezipienten und/oder einer sie umgebenden Hilfselektrode mit gleichem Potential beaufschlagt werden.

Die bekannten Plasmaätzvorrichtungen werden zur Durchführung des erfindungsgemäßen Verfahrens dahingehend verändert, daß die beiden parallel zueinander angeordneten Elektroden aus fest oder beweglich im Rezipienten angeordneten Platten, die auf den zueinanderweisenden Flächen mit Substraten belegbar sind, bestehen und beide Platten an das gleiche Potential des HF-Generators gelegt sind und dass der die Platten umgebende Rezipient und/oder eine die Platten ringförmig umgebende Hilfselektrode an das andere Potential des HF-Generators gelegt ist bzw. sind.

Das Plasma wird hierbei zwar durch Gegenelektrode und Substratelektroden erzeugt, aber das Plasma erstreckt sich nur zwischen den mit Substraten belegten auf gleichem Potential liegenden Elektroden. Dieses Plasma ist bedeutend intensiver und gleichmässiger als bei den bekannten Diodenanordnungen.

Vorteilhafterweise sind dabei beide Elektroden leitend miteinander verbunden. Zwecks einer günstigen automatischen Be- und Entladung des Reaktionsraumes ist die Elektrodeneinheit als schleusbare Kassette ausgebildet. Nach einer weiteren vorteilhaften Ausführung sind die mechanisch voneinander unabhängigen leitend miteinander verbundenen Elektroden oder Kassetten stapelförmig in der Anlage angeordnet.

Diese elektrisch wie mechanisch symmetrischen Ätzanordnungen bewirken gegenüber den bekannten asymmetrischen Ätzanordnungen eine grundsätzlich andere, gleichmäßige und intensive Plasmaentladung. Durch die über die Elektrodenflächen homogene Plasmaverteilung wird der durch das Plasma bedingte Wärmefluß zu den Elektroden und damit die daraus resultierende Temperaturverteilung räumlich homogen. Dadurch kann ein größerer Anteil der Elektrodenfläche mit Substraten belegt werden als bisher, beziehungsweise es entfallen aufwendige Varianten einer Substratbewegung zur Homogenisierung. Da außerdem beide Parallelplatten bei der erfindungsgemäßen Lösung mit Substraten belegt werden, erhöht sich die Arbeitsproduktivität gegenüber den bekannten Vorrichtungen wenigstens um das Doppelte.

Die erfindungsgemäßen Elektrodenausführungen ermöglichen eine lokalisierte Plasmaentladung in wesentlich niedrigeren Druckbereichen als asymmetrische Anordnungen, ohne daß dazu Abschirmungen erforderlich sind. Bei diesem niedrigen Arbeitsdruck wird durch die wesentlich vergrößerte freie Weglänge im Reaktionsgas eine entscheidende (zusätzliche) Verbesserung der Homogenität erreicht. Bei Verwendung von Fluor- oder Chlor-Kohlenwasserstoffen als Prozeßgase fallen höhermolekulare Verbindungen als Reaktionsprodukte an, die sich bei den bekannten unsymmetrisch aufgebauten Anordnungen in unterschiedlicher Weise im Substratbereich abscheiden. Das erfindungsgemäße Verfahren gestattet eine Optimierung der Plasmaabscheidung der gestalt, daß im gesamten Substratbereich eine Abscheidung derartiger Produkte vermieden wird.

Ausführungsbeispiel

Die Erfindung wird an Hand einer Zeichnung näher erläutert. Dabei zeigt :

Figur 1 einen schematischen Aufbau eines Rezipienten mit Parallelplattenelektrode

Figur 2 einen Rezipienten mit Kassettenelektrode

Figur 3 einen Rezipienten mit stapelförmig angeordneten Kassettenelektroden.

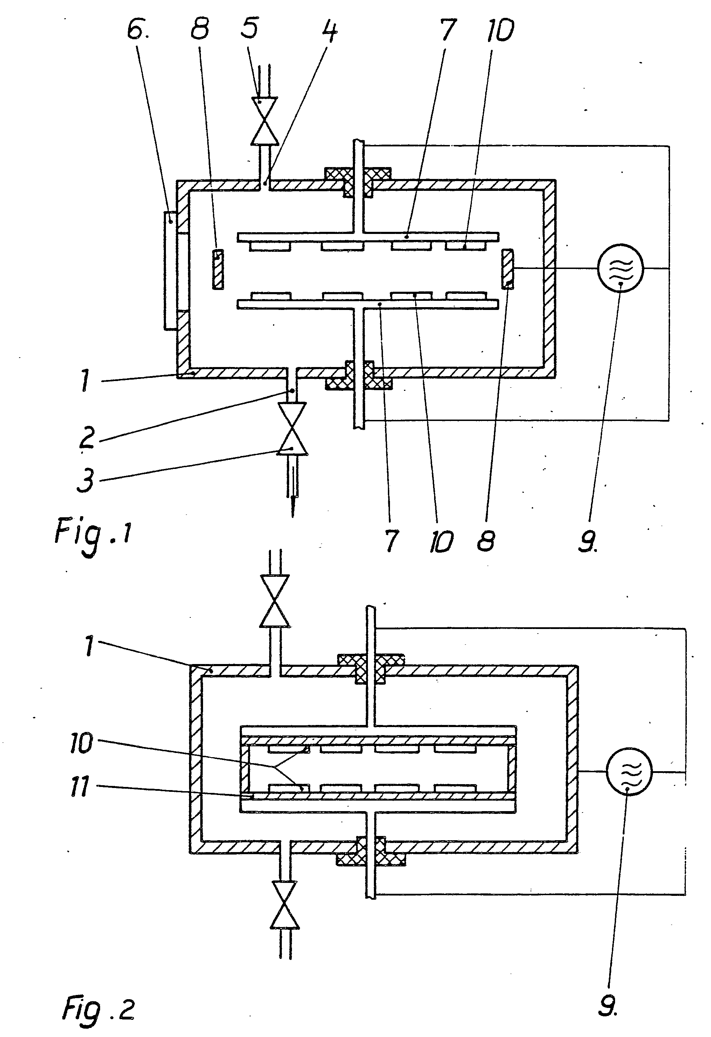

In dem Rezipienten 1 erstreckt sich das Plasma hauptsächlich zwischen zwei oder mehreren in einem von den Entladungsbedingungen abhängigen Abstand parallel zueinander angeordneten Elektroden. Diese werden gegenüber dem sie umgebenden Rezipienten 1 oder einer sie umgebenden Hilfselektrode 8 mit gleichem Potential beaufschlagt. Dabei sind die Elektroden auf den zueinanderweisenden Flächen mit Substraten 10 belegt. In Fig. 1 sind die beiden Elektroden 7 als zwei parallel zueinander angeordnete und mit Substraten 10 belegte Platten dargestellt. Beide Elektroden 7 sind gegenüber der Hilfselektrode 8 auf gleiches Potential gelegt. Der Rezipient 1 ist mit einer Saugleitung 2 und einer Gasversorgungsleitung 4 versehen. Die dazugehörigen Absperrventile sind mit 3 und 5 bezeichnet. Zur Einbringung der Substrate 10 in den Rezipienten 1 ist eine Beschickungsluke 6 vorgesehen. Der HF-Generator ist mit 9 bezeichnet. Zwecks einer günstigen automatischen Be- und Entladung des Reaktionsraumes des Rezipienten 1 ist in Fig. 2 die Elektrodeneinheit als schleusbare Kassette 11 dargestellt. Eine weitere vorteilhafte Ausführungsform der Elektroden 7 zeigt die Fig. 3. Hierbei sind zur gleichzeitigen Bearbeitung im Rezipienten 1 die Kassetten 11 stapelförmig angeordnet. Zur Gewährleistung der Einstellbarkeit und Gleichmäßigkeit der Temperatur sind die Kassetten 11 in wahlweise heizbeziehungsweise kühlbaren Halterungen 12 angeordnet.

Die Halterung 12 ist dabei mit dem HF-Generator 9 verbunden.

Die in den Fig. 1 bis 3 dargestellten Elektrodenanordnungen stellen elektrisch wie mechanisch symmetrische Anordnungen dar, die eine intensive und gleichmäßige Plasmaentladung über die gesamten Elektrodenflächen ermöglichen (Hohlkatodeneffekt).

**Ansprüche**

1. Verfahren zum Plasmaätzen oder zur Plasma CVD in einem Rezipienten, in dem zwischen zwei Elektroden ein Plasma ausgebildet wird, gekennzeichnet dadurch, daß das Plasma sich hauptsächlich zwischen zwei oder mehreren in einem von den Entladungsbedingungen abhängigen Abstand parallel zueinander angeordneten mit Substraten belegten und mit gleichem Potential beaufschlagten Elektroden erstreckt und daß der die Elektroden umgebende Rezipient und/oder eine diese Elektroden umgebende Hilfselektrode mit dem anderen Potential beaufschlagt wird (werden).

2. Vorrichtung zum Plasmaätzen oder zur Plasma CVD, bestehend im wesentlichen aus einem mit Elektroden ausgerüsteten Rezipienten, HF-Generator, Vakuumpumpe und Gaszuleitung, insbesondere zur Durchführung des Verfahrens nach Anspruch 1, gekennzeichnet dadurch, daß die bieden parallel zueinander angeordneten Elektroden aus fest oder beweglich im Rezipienten angeordneten Platten, die auf den zueinanderweisenden Flächen mit Substraten belegbar sind, bestehen und beide Platten mit dem gleichen Ausgang des HF-Generators verbunden sind und daß der die Platten umgebende Rezipient und/oder eine die Platten ringförmig umgebende Hilfselektrode mit dem anderen Ausgang des HF-Generators verbunden ist (sind).

3. Vorrichtung nach Anspruch 2, gekennzeichnet dadurch, dass die beiden Elektroden leitend miteinander verbunden sind.

4. Vorrichtung nach Anspruch 2 und 3, gekennzeichnet dadurch, daß die beiden Elektroden als schleusbare Kassette ausgebildet sind.

5. Vorrichtung nach Anspruch 2 bis 4, gekennzeichnet dadurch, daß die mechanisch voneinander unabhängigen elektrisch leitend miteinander verbundenen parallelen Elektroden oder Kassetten stapelförmig in der Anlage angeordnet sind.

## Claims

1. Process for plasma etching or for plasma chemical-vapour deposition in a receptacle in which a plasma is formed between two electrodes, characterised in that the plasma extends mainly between two or more electrodes which are arranged parallel to one another at a distance dependent on the discharge conditions and are covered with substrates and which are subjected to the same potential, and in that the receptacle surrounding the electrodes and/or an auxiliary electrode surrounding these electrodes are subjected to the other potential.

2. Apparatus for plasma etching or for plasma chemical-vapour deposition, consisting essentially of a receptacle equipped with electrodes, a high-frequency generator, a vacuum pump and a gas delivery line, especially for carrying out the process according to claim 1, characterised in that the two electrodes arranged parallel to one another consist of plates which are arranged fixedly or movably in the receptacle and which can be covered with substrates on surfaces pointing towards one another, and the two plates are connected to the same output of the high-frequency generator, and in that the receptacle surrounding the plates and/or an auxiliary electrode surrounding the plates annularly are connected to the other output of the high-frequency generator.

3. Apparatus according to claim 2, characterised in that the two electrodes are connected conductively to one another.

4. Apparatus according to claims 2 and 3, characterised in that the two electrodes are designed as an insertable cassette.

5. Apparatus according to claims 2 to 4, characterised in that the parallel electrodes or cassettes which are mechanically independent from one another and which are connected electrically conductively to one another are arranged in the form of a stack in the apparatus.

## Revendications

1. Procédé de décapage au plasma ou le dépôt au plasma (Plasma CVD), dans un récipient dans lequel on engendre un plasma entre deux électrodes, caractérisé en ce que le plasma se trouve principalement entre deux électrodes, ou davantage, parallèles les unes aux autres, à un intervalle qui est fonction des conditions de décharge, recouvertes de substrats et portées au même potentiel, et en ce que le récipient qui entoure les électrodes, ou une électrode auxiliaire qui les entoure, ou les deux, est, ou sont, portés à l'autre potentiel.

2. Dispositif de décapage au plasma ou pour le dépôt au plasma (Plasma CVD), comportant essentiellement un récipient équipé d'électrodes, un générateur haute fréquence, une pompe à vide et une conduite d'alimentation en gaz, en particulier pour la mise en œuvre du procédé suivant la revendication 1, caractérisé en ce que les deux électrodes qui sont disposées parallèlement les unes aux autres, sont des plaques fixes ou mobiles montées dans le récipient et qui peuvent être recouvertes de substrats sur leurs surfaces dirigées l'une vers l'autre, et en ce que ces deux plaques sont reliées à la même sortie du générateur haute fréquence et que le récipient qui entoure les plaques, ou une électrode auxiliaire qui les entoure à la façon d'un anneau, ou les deux, est ou sont reliés à l'autre sortie du générateur haute fréquence.

3. Dispositif selon la revendication 2, caractérisé en ce que les deux électrodes sont reliées l'une à l'autre de façon conductrice.

4. Dispositif selon les revendications 2 et 3, caractérisé en ce que les deux électrodes sont réalisées sous la forme d'une cassette pouvant passer par un sas.

5. Dispositif selon l'une des revendications 2 à 4, caractérisé en ce que les électrodes ou les cassettes parallèles reliées électriquement entre elles, et indépendantes les unes des autres sur le plan mécanique, sont disposées dans le dispositif sous forme d'un empilement.

Fig .1

Fig .2

1

Fig.3